# EUROPEAN PATENT APPLICATION

(11) **EP 1 189 276 A1**
(43) Date of publication of application: **20.03.2002**
(21) Application number: 00402501.1
(22) Date of filing: 08.09.2000
(51) Int. Cl.: H01L 21/8234, H01L 21/8238

(54) **Methods of making an integrated circuit having field implants and a high voltage PN junction, and corresponding integrated circuit**

(71) Applicant: INTERUNIVERSITAIR MICRO-ELEKTRONICA CENTRUM VZW, 3001 Heverlee (BE); ALCATEL, 75008 Paris (FR)
(72) Inventor: Vermandel, Miguel, 8340 Sijsele (BE); Van Calster, André, 9070 Heusden (BE); Van Hove, Hugo, 9680 Maarkedal (BE); Tack, Marnix, 9820 Merelbeke (BE); Moens, Peters, 9620 Zottegem (BE)
(74) Representative: Van Malderen, Joelle

(57) **Abstract**

The present invention relates to a method of processing a high voltage p++/n-well junction (7;43;40) in a standard submicron CMOS process wherein a first implantation step is carried out to form p-type field implants (53) in a p-well region (50) and a separate, second implantation step is carried out in the n-well region (2;40) in a zone surrounding said junction, in order to provide or modify a p-type high voltage region (6;46;47) around said junction.

## Description

### Field of the invention

The present invention is related to a high voltage p++/n-well junction in a standard submicron CMOS technology.

### State of the art

High voltage p++/n-well junctions in standard CMOS technologies are known in such applications as high voltage PDEMOS (P-Drain Extended MOS) or high voltage floating p++/n-well diodes. A PDEMOS device is described in 'A High Voltage p-type Drain Extended MOS in a Low Voltage Sub-micron CMOS Technology', Vermandel et al., ESSDERC, 1998, p. 492-495. The device described in this document has a lowly doped p-type implant underneath the field oxide of the PDEMOS, acting as a 'drift region' and coinciding substantially with the surface of said field oxide. This gives the advantage of introducing a self-aligned p-type implant, facilitating the design of such a device. Moreover, the cited document suggests a method whereby this type of p-type implant is introduced simultaneously with the other p-field implants underneath the field oxide in the adjacent p-well regions. The latter type of implants have a different function, namely to suppress the operation of so-called parasitic field transistors in the vicinity of the field oxides in said p-well regions. Since both implants are of the same type, the cited document points at the advantage of creating them in the same processing step. Still, the different function of both implants raises problems, acknowledged by the cited document, which continues to present a study resulting in the influence of some process parameters on the characteristics of both types of implants. However, a disadvantage remains in the fact that optimising the p-type implant underneath the PDEMOS-field oxide will also influence the ordinary transistors (e.g. effective width) and the parasitic field transistors (e.g. threshold voltage) in an unintended way.

In the design of PDEMOS devices, another type of implant has been described in 'High Voltage CMOS LCD Driver Using Low Voltage CMOS process', J. Haas et al., CICC'89, p. 14.6.1-14.6.4. In this document, a p-implant is applied underneath the p++/n-well junction in order to achieve a smoother gradient of the junction, augmenting its breakdown voltage. A problem in this design is that it does not allow a self-aligned implant.

### Aims of the invention

The present invention aims to provide a method of processing a high voltage p++/n-well junction, with a high breakdown voltage, said method allowing the application of a self-aligned p-type implant.

The present invention equally aims to provide a device, comprising such a high voltage p++/n-well junction.

### Summary of the invention

The present invention is related to a method of processing a high voltage p++/n-well junction in a standard submicron CMOS process, on a substrate comprising at least one n-well region and one p-well region, characterised in that a separate implantation step is done in a zone surrounding said high voltage p++/n-well junction, in order to acquire a p-type implant region adjacent to said junction.

According to a first preferred embodiment of the present invention, the method comprises the following steps:
- defining the active areas both on said n-well regions and said p-well regions on said substrate,
- implanting in a first implantation step the p-field implants in said p-well regions as well as the p-type implants around said high voltage p++/n-well junctions in said n-well regions,
- implanting in a second, separate implantation step said p-type implants around said high voltage junctions in said n-well regions, to modify the characteristics of said p-type implants in said n-well regions, independently from said p-field implants in said p-well regions,
- further steps to grow the field oxide and to further process the active areas.

According to a second preferred embodiment of the present invention, the method comprises the following steps:
- defining the active areas both on said n-well and said p-well regions on said substrate,
- implanting in a first implantation step the p-field implants in said p-well regions,
- implanting in a second, separate implantation step the p-type implants around said high voltage junctions in said n-well regions, independently from the p-field implants in said p-well regions,
- further steps to grow the field oxide and to further process said active areas.

According to a third preferred embodiment of the present invention, the method comprises the following steps:
- defining the active areas both on said n-well and said p-well regions on said substrate,
- implanting in a first implantation step the p-field implants in said p-well regions,
- growing the field oxide,
- implanting in a second, separate implantation steps the p-type implants around said high voltage junctions in said n-well regions,
- further processing said active areas.

According to the present invention, an annealing step is performed after said separate implantation step, the anneal time of said annealing step being between 60 minutes and 120 minutes.

According to the first and second embodiment of the present invention, the implantation dose of said separate p-type implantation step in the n-well lies between 6.10¹³/cm² and 1.2 . 10¹⁴/cm².

Further according to the present invention, the implantation energy of said separate p-type implantation step in the n-well is lying between 40 keV and 60 keV for a BF₂ implant.

According to the third embodiment, the implantation energy of said separate implantation step is preferably between 150 keV and 300 keV for a B implant.

The present invention is also related to a device containing a high voltage p++/n-well junction, produced by the method according to the invention.

Such a device may be a P-Drain Extended MOS or a high voltage floating p++/n-well diode.

In a device according to the present invention, the active area definition width (as designed) of the p++ region is lying between 1.6 µm and 8 µm.

### Short description of the drawings

Fig. 1 represents a PDEMOS device, according to the state of the art.

Fig. 2 represents the basic structure of the high voltage p++/n-well junction without p-type implants.

Fig. 3 represents the basic structure with p-type implants.

Fig. 4+5 illustrate the influence of the n-well/p-substrate junction.

Fig. 6 illustrates the influence of the width of the p++ region.

Fig. 7 illustrates the influence of the width of the p++ region on the breakdown voltage.

Fig. 8 illustrates the influence of the implant dose and anneal time of the p-type implant on the breakdown voltage.

Fig. 9 represents a PDEMOS device according to the present invention.

Fig. 10 illustrates a simulation of the influence of the p++ region width on the breakdown voltage.

Fig. 11 illustrates a simulation of the influence of the p-type implant depth on the breakdown voltage.

Fig. 12 illustrates a simulation of the influence of the p-type implant width on the breakdown voltage.

Fig. 13 illustrates the influence of the width of the p-type implant for different implant doses.

### Detailed description of the invention

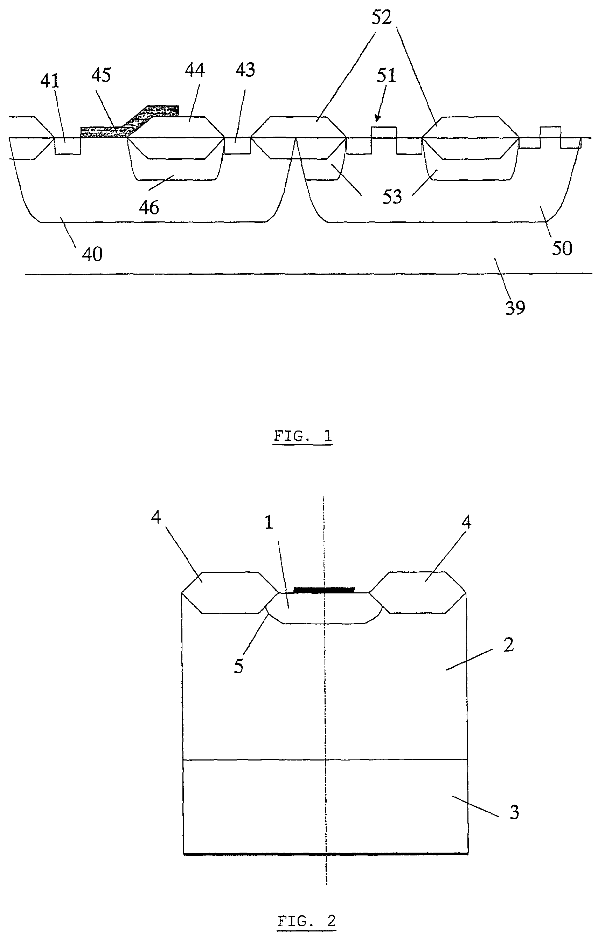

The present invention is related to a method of providing a low-doped p-type implant underneath a field oxide, next to a high voltage p++/n-well junction, such as a PDEMOS drain or high voltage diode. In standard CMOS technology, a substrate is divided into a number of n-well regions and p-well regions, by respectively doping these regions with e.g. Phosphorus and Boron atoms. In these n-well and p-well regions, active areas are then created, containing transistors or diodes, said active areas being separated by regions made of field oxide. A p-field implant is normally applied underneath field oxide regions in the p-well, in order to enhance the threshold voltage of the parasitic transistors which are inherently created with said field oxide regions. In the n-well, a p-type implant is normally not applied underneath the field oxide, except e.g. underneath the field oxide 44 of a high voltage transistor, such as a PDEMOS, see figure 1, implant 46. In this last case, the p-type implant does not serve to increase the threshold voltage but serves as a drift region with a constant resistance, extending the drain to the channel and allowing the proper functioning of this high voltage device. As stated above, prior methods have focused on producing both types of p-implants, i.e. in p-well and simultaneously in regions of the n-well, in one step, thereby diminishing the capability of optimising the characteristics of the implant near the high voltage junction. The present invention describes a processing method which does allow said optimisation. Furthermore, the present invention allows to produce high voltage p++/n-well junctions with improved breakdown behaviour because of the characteristics of the p-type implants.

Using the present invention allows the external applied voltages to be in the order 80, preferably 70, more preferably 60V.

According to a first embodiment of the method according to the invention, the method comprises the following steps:
- defining the active areas both on the n-well and the p-well regions on the substrate. By defining is meant the covering of said active areas by a mask, whereby the active areas are covered by a nitride layer, to protect them from the following implantation steps.
- implanting in a first implantation step e.g. with Boron or BF₂ the p-field implants in the p-well regions as well as in some areas of the n-well regions, e.g. the location of the field oxide in high voltage devices such as PDEMOS,
- implanting in a second, separate implantation step e.g. with B or BF₂ the p-type implants in the n-well regions, to modify the characteristics of said p-type implants, independently from the p-field implants in the p-well regions,
- further steps to grow the field oxide and to further process the active areas.

The third step requires an additional mask and an additional implantation step, but gives the advantage that the characteristics of the p-type implants in the n-well (in high voltage devices) can be tuned without influencing the ordinary transistors in the p-well.

According to a second embodiment of the present invention, the method comprises the following steps
- defining the active areas both on the n-well and the p-well regions on the substrate,
- implanting in a first implantation step the p-field implants in the p-well regions,
- implanting in a second, separate implantation step, the p-type implants in the n-well regions, independently from the p-field implants in the p-well regions,
- further steps to grow the field oxide and to further process the active areas.

This embodiment also requires an additional mask and an additional implantation step, but now the creation of the p-type implant in the n-well is done totally independently of the p-field implant in the p-well.

The first embodiment is especially suited for cases wherein all p-type implants are coinciding with field oxide regions, in other words wherein self-aligned p-type implants are produced.

The second embodiment can equally be used for these self-aligned implants, but also for implants which coincide with less than the total field oxide surface. It can for example be advantageous to have a p-type implant surrounding a high voltage p++/n-well junction in its immediate vicinity, which may be the case for high voltage diodes.

According to a third embodiment of the present invention, the implantation of the p-type implants around the high voltage junction is done after the growing of the field oxide regions. This means that the implant is done through this field oxide.

In this case higher energies are required (range 150 - 300 keV for a B implant) to be able to implant the p-type doping through the field oxide to dope the region underneath the field implant. This embodiment has the advantage that during the growth of the field oxide no dopants already present at the field regions are being absorbed by the field oxide leading to a smaller effective doping of the p- regions. The implantation dose of said separate implantation step according to the third embodiment is preferably lying between 5.10¹¹/cm² and 1.10¹³/cm².

The nitride covering the 'active area will stop the implant, so the active area is not doped, while the implants can still get through the oxide.

All three embodiments are characterised by the fact that a separate implantation step is performed, wherein the p-type implant in the immediate vicinity of the high voltage p++/n-well junction is produced.

Both embodiments comprise additional steps, other than the ones mentioned above, the latter being the only ones relevant to the present invention. Steps not mentioned above are printing steps, cleaning steps, annealing steps, etc. It is considered that a man skilled in the art is aware of the functionality and technicality of such steps.

Since in the above-described method, all implantation steps are performed after the definition of the active areas, there is no possibility of having such a p-type implant extending under the p++ region of a high voltage p++/n-well junction, as described in the prior art. However, the present invention does allow to produce such a high voltage junction, surrounded by one or more p-type implants of which the characteristics can be tuned at will. In the following, it is shown that this feature allows to increase the breakdown voltage of the junction accordingly, thereby avoiding the need for the 'intermediate' p-type implant described by Haas et al.

Figure 2 shows the basic structure of a high voltage p++/n-well junction without p-type implants. The structure consists of a highly doped p++ region 1 in a low-doped n-layer 2, the n-well, placed on a low-doped p-substrate 3. The p++ region 1 might represent the drain of a PDEMOS transistor which is put at the same negative voltage as the p-substrate, with respect to the n-well. A layer of field oxide 4 surrounds the p++ region 1. The p++/n-well junction must remain reverse-biased at all times. Breakdown will occur at the vertical p++/n-well junction, underneath the bird's beak 5, due to the sharp curvature of the junction there.

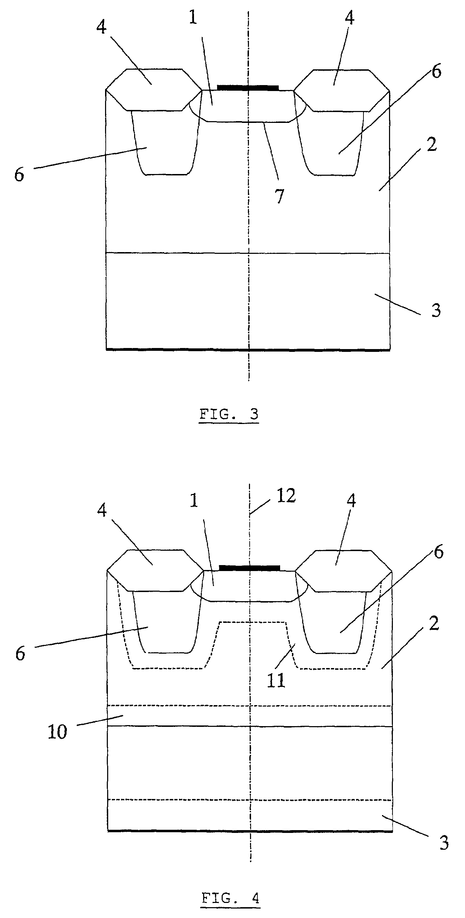

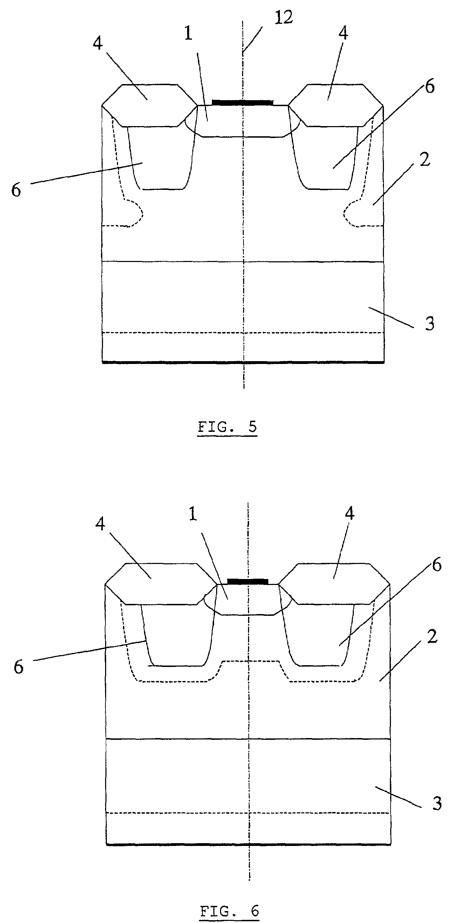

Figure 3 illustrates the same structure, this time with the low doped p-type implant 6 around the p++ region. The p-type implant may or may not coincide with the field oxide. It is assumed that the implant 6 is surrounding the p++ region in all directions. If the method according to the invention is used, the p-type implant may not extend beyond said field oxide, i.e. under the active area. This is impossible, as the creation of the p-type implant is done after the definition of the active areas. Still, the p-type implant according to the invention has a beneficial influence on the p++/n-well junction, as is explained after this. The immediate result of the p-type implant around region 1 is that the breakdown region is shifted to the horizontal part of the p++/n-well junction 7. This results in a first increase in the breakdown voltage. Depending on the width of the p++ region, the dose and depth of the p-implant and the depth of the n-well, two different phenomena can further increase the breakdown voltage.
1. The influence of the n-well/p-substrate junction (figure 4+5)
   - Fig. 4 shows the depletion areas around the n-well/p-substrate junction (area 10) and around the n-well/(p++ and p-) implant junction (area 11). In this figure 4, both areas 10 and 11 are separated. This means that the breakdown voltage is mainly determined by the horizontal p++/n-well junction.
   - Fig. 5 shows the case where both areas 10 and 11 reach each other, leaving the p++/n-well junction isolated from the rest of the n-well, at the bottom by the depletion area, at the side by the p-type implant. The result is that the vertical potential drop along the cut line 12 is less high, reducing the electric field far below the critical value. A much higher voltage can be applied to the n-well before breakdown occurs.

   The effect illustrated in figure 5 is dependent on the doping levels of the n-well and on the depth and the doping levels of the p-type implant. Since the present invention offers a method in which the p-type implant characteristics can be optimised without endangering the operation of the ordinary transistors in the p-well, this effect can be more easily obtained using the method according to the present invention.
2. The influence of the p++ region
   - For a wide p++ region (figure 3), the vertical depletion of the p-implant underneath the field oxide does not influence the horizontal p++/n-well junction.
   - For a less wide p++ region, the effect shown in figure 6 becomes apparent. The depletion of the vertical junction of the p-type implant underneath the field oxide starts to reinforce the depletion of the horizontal p++ implant. For the same applied voltage, the potential lines are more stretched out vertically into the n-well, resulting in a lower electric field. This results in the necessity of a higher voltage to reach the critical electric field and breakdown.

The effect illustrated in figure 6 may also be enhanced by the method of the invention, which allows the optimised tuning of the doping level of the p-type implant, which is related to the thickness of the depletion zones.

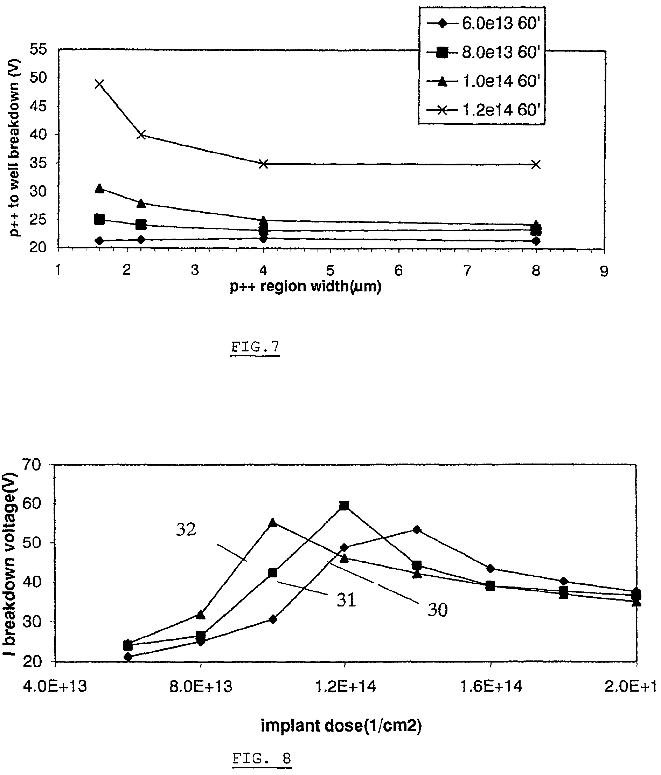

The active area definition width of the p++ regions (i.e. as designed) in high voltage devices according to the present invention, is lying between 1.6 µm and 8 µm, with the smaller values enhancing the effect described above, as can be seen on figure 7, for different values of the implantation dose of the separate implantation step.

As explained in points 1 and 2, the depth and the doping level of the separate p-type implant are determining the eventual breakdown voltage of the p++/n-well junction. These parameters are depending on the process parameters with which the p-type implant has been created. The most important of these parameters are: implantation dose, implantation energy, anneal time and anneal temperature. The annealing is a necessary step after any implantation step. Prior research has looked for those processing characteristics of the p-type implants which influenced the implants in the n-well (high voltage device) in a positive way, while influencing as little as possible the implants in the p-well. As a result, it was found that the implant dose and the anneal time had the least influence on the ordinary MOS devices and were therefore most suited in order to optimise the p-type implants next to high voltage junctions in the n-well. With the method of the present invention, the p-type implants in n-well and p-well can be tuned independently, so other parameters (e.g. anneal temperature) may be regarded as useful to optimise the high voltage p-type implant.

Figure 8 shows a graph wherein the effect on the breakdown voltage of the doping level and of the anneal time of the separate p-type implant in the n-well, is illustrated. Curve 30 shows the breakdown voltage as a function of p- implant implantation dose for an anneal time of 60 minutes. Curve 31 shows the same for an anneal time of 90 minutes. Curve 32 corresponds to an anneal time of 120 minutes. All three curves have a maximum, which can be explained as follows:

Increasing the implantation dose of the separate p-implant will at first increase the depletion width of the vertical p-/nwell junction and thus increase the influence on the horizontal p++/n-well junction, augmenting its breakdown voltage. However, for a certain doping level, the p- implant becomes a good conductor, which leads to a shifting of the place of breakdown to the p-/Nwell junction. For higher doping levels, the breakdown voltage decreases. The upper limit of the anneal time (120minutes) needs to be imposed in order to avoid diffusing of the implant to regions under the active areas.

It is clear from figure 8 that the anneal time causes the breakdown voltage to increase, as long as the doping level is not too high. This is because the p-type implant depth is directly related to this anneal time: higher anneal times yield higher implant depths. Increasing the p-type implant depth increases its influence on the horizontal p++/n-well junction, augmenting in this way the breakdown voltage.

It is emphasised once more, that the method of the present invention allows the use of other process parameters to optimise the breakdown voltage of the p++/n-well junction, since the p-type implant next to said junction can be tuned independently from the other implants. Preferred implantation doses of the separate p-type implantation step (i.e. this independent p-type implant) according to the present invention are lying between 6.10¹³/cm² and 1.2 . 10¹⁴/cm² for BF₂. Preferred implantation energy is lying between 40 keV and 60 keV for the first and second embodiment for a BF₂ implant, and between 150 keV and 300 keV for the third embodiment, for a B-implant. Preferred implant doses for this B-implant are lying between 5.10¹¹/cm² and 1.10¹³/cm². Preferred anneal time after the separate implantation step for all preferred embodiments is lying between 60 minutes and 120 minutes.

According to the second embodiment of the present invention, the size of the p-type implant is not defined by the size of the field oxide on top of it. The p-type implant may be smaller than said field oxide and extend only to a given region around the p++/n-well junction. This leads to the opportunity of optimising the size of the implant in order to maximise the breakdown voltage of said junction.

### Example 1: PDEMOS

Figure 1 is showing a PDEMOS device known in the state of the art, placed in an n-well region 40, itself created on a low doped p-substrate 39. The device consists of a source 41, drain 43, field oxide 44, gate 45, p-type implant 46. Figure 1 equally shows a p-well region 50 next to the n-well 40, containing an active area 51, for example an ordinary nMOS device, and a field oxide region 52, with a low doped p-field implant 53 underneath. With the state of the art methods, both implants 46 and 53 are implanted in the same step, using one mask. However, this may cause problems for both types of implant: implant 46 might have an insufficient doping level, leading to a bad connection between the implant and the drain; in the p-well, the effective width of the nMOS transistors may be badly affected.

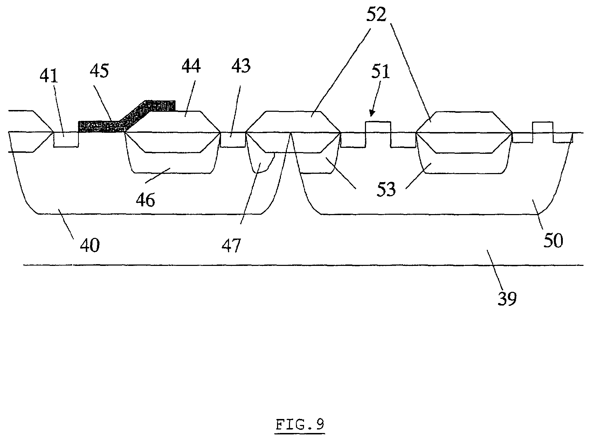

With the method of the invention, both implants can be created independently. Moreover, the p-type implant in the n-well may be extended so that it surrounds the drain completely (see figure 9, zones 46+47), thereby allowing the described reduction in breakdown voltage. The separate implantation step according to either of the embodiments of the invention allows the optimisation in terms of doping level, depth and width of the implant zones 46 and 47, without deteriorating the implants 53 in the p-well.

### Example 2: High voltage p++/n-well diode.

A device of this type is in fact shown in figure 4. It consists of the p++/n-well junction, whose breakdown voltage can be limited by the surrounding p-type implant. To produce a device of this kind, the second embodiment of the invention is preferably used, as this gives the opportunity to optimise the size of the implant around the junction.

### Simulation plots

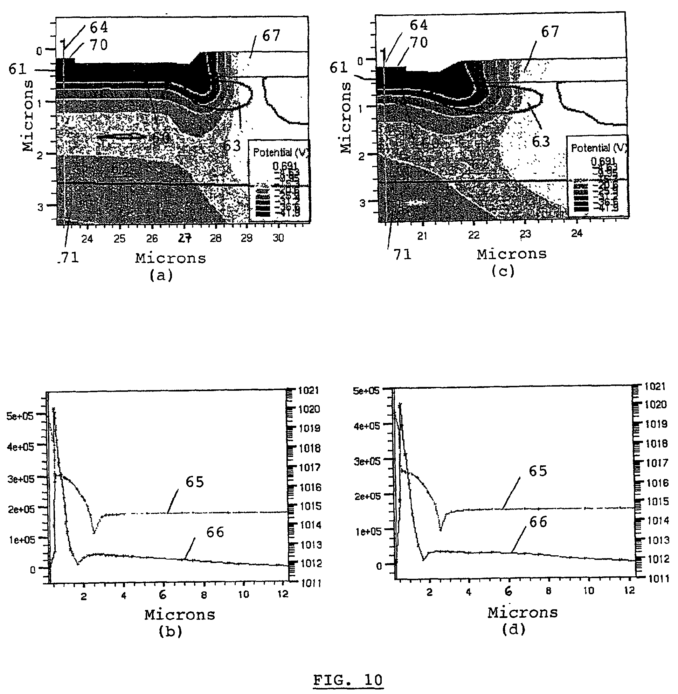

The plots in figures 10, 11 and 12 are derived from a 2-dimensional device simulation and illustrate some of the effects described above.

In figure 10, a comparison is made between a p++ region having an active area width as designed of 8 µm (fig. 10a+b) and a p++ region having an active area width as designed of 2.2 µm (Fig. 10 c+d), both for an implant dose of 1.10¹⁴/cm² BF₂ and an implantation energy of 50 keV. The top figures (a and c) show both structures, consisting of the junction 60, the p++ region 61, n-well 62, p-type implant 63, field oxide 67. Only half of the structure is shown in both cases. The dimensions in both directions are indicated in microns. The curves 65 are showing the net doping level as a function of the distance along the cut line 64, starting from the surface. The difference in doping level between p++ region, n-well, and substrate can be clearly seen. In the simulation shown, the p++ contact 70 and the substrate 71 are at the same voltage of -42V with respect to the n-well. The curves 66 show the electric field along the cut line. It can be seen that for a less wide p++ region, the electric field underneath the junction is decreased, leading to a an increase in the external voltage which can be applied before breakdown occurs and thus to an increase in breakdown voltage of such a device.

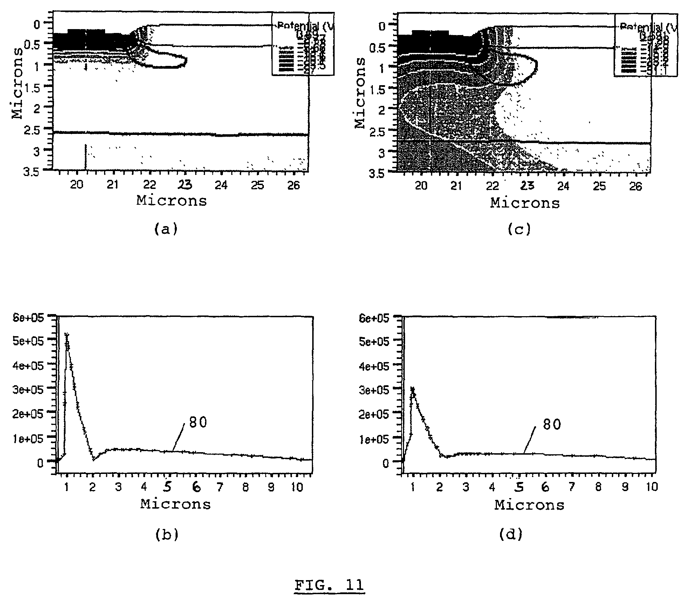

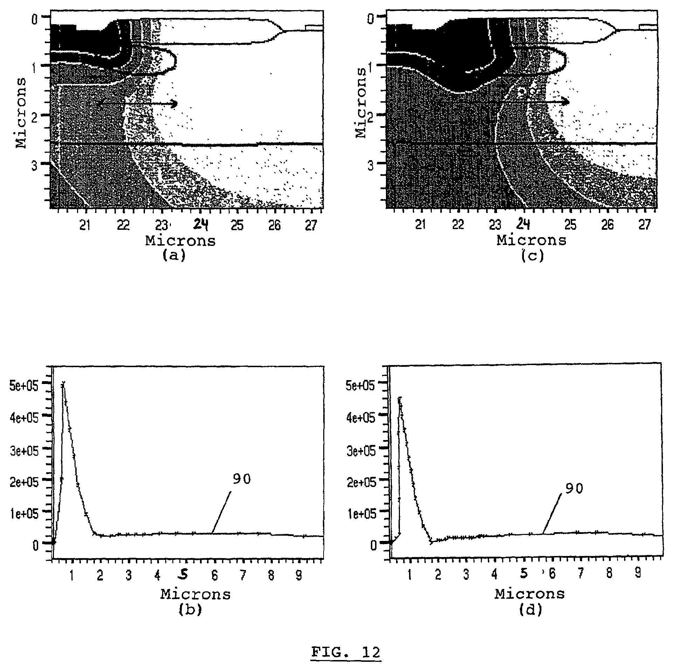

Figure 11 illustrates in the same way the effect of the separate p-type implant depth, figures 11c+d showing the influence of a significant increase in this implant depth with respect to figures 11a+b. All drawings in figure 11 are related to a p++ region and substrate at a voltage of -27V with respect to the n-well. Figures 11a and 11c are related to an implant with a dose of 6.10¹³/cm² BF₂ at 50 keV. The implant in figure 11c is made in the same way, but a separate implantation is done after the growing of the field oxide, said latter implant being B, at 2.10¹²/cm² and 200 keV. The references in figures 10a and 10c are equally valid in figures 11a+c and 12a+c. The curves 80 indicate a clear drop in the electric field values, and thus an increase in breakdown voltage.

Figure 12 illustrates in the same way the influence of the active area p-type implant definition width; figures 12a+b are related to an active area p-type implant definition width of 2 µm, figures 12c+d are related to an active area p-type implant definition width of 3.5 µm. All drawings in figure 12 are related to a BF₂ implant at 1.10¹⁴/cm² and 50 keV. In all drawings of figure 12, the p++ region and the substrate are at a voltage of -65 V with respect to the n-well. The curves 90 show a decrease in the electric field for the wider implant, and thus an increase in breakdown voltage for such a device.

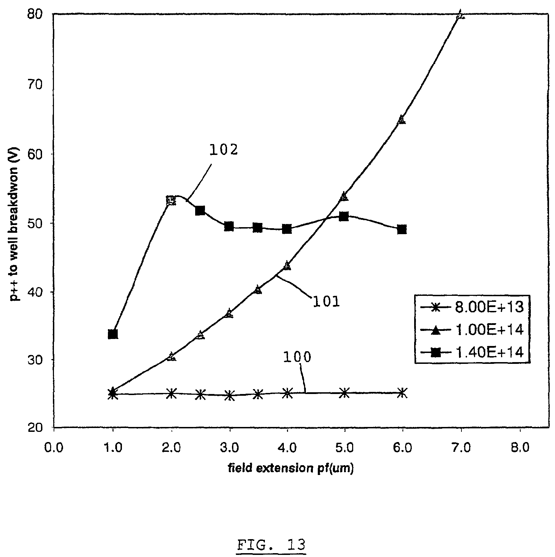

The effect of figure 12 is dependent upon the implantation dose, as can be seen in figure 13. Three curves are representing the breakdown level as a function of the active area p-type implant definition width pf, for three implantation doses: curve 100 (8.10¹³/cm²), curve 101 (1.10¹⁴/cm²), and curve 102 (1.4 . 10¹⁴/cm²). Curve 101 (moderate implantation dose) shows a clear increase in the breakdown level as a function of rising pf. As the implantation dose increases, this is no longer the case, because the place of breakdown is shifted to the p-implant/n-well junction.

## Claims

1. A method of processing at least one high voltage p++/n-well junction in a standard submicron CMOS process, on a substrate comprising at least one n-well region and at least one p-well region, **characterised in that** a separate implantation step is done in a zone surrounding said high voltage p++/n-well junction, in order to acquire a p-type implant region adjacent to said junction.

2. A method according to claim 1, comprising the following steps:
- defining the active areas both on said n-well regions and said p-well regions on said substrate,
- implanting in a first implantation step the p-field implants in said p-well regions as well as the p-type implants around said high voltage p++/n-well junctions in said n-well regions,
- implanting in a second, separate implantation step said p-type implants around said high voltage junctions in said n-well regions, to modify the characteristics of said p-type implants in said n-well regions, independently from said p-field implants in said p-well regions,
- further steps to grow the field oxide and to further process the active areas.

3. A method according to claim 1, comprising the following steps:
- defining the active areas both on said n-well and said p-well regions on said substrate,
- implanting in a first implantation step the p-field implants in said p-well regions,
- implanting in a second, separate implantation step the p-type implants around said high voltage junctions in said n-well regions, independently from the p-field implants in said p-well regions,
- further steps to grow the field oxide and to further process said active areas.

4. Method according to claim 1, comprising the following steps
- defining the active areas both on said n-well and said p-well regions on said substrate,
- implanting in a first implantation step the p-field implants in said p-well regions,
- growing the field oxide,
- implanting in a second, separate implantation steps the p-type implants around said high voltage junctions in said n-well regions,
- further processing said active areas.

5. A method according to any one of claims 1 to 4, wherein an annealing step is performed after said separate implantation step, the anneal time of said annealing step being between 60 minutes and 120 minutes.

6. A method according to any one of claims 1 to 3, wherein the implant dose of said p-type implant lies between 6.10¹³/cm² and 1.2 . 10¹⁴/cm² for BF₂.

7. A method according to any one of claims 1 to 3, wherein the implantation energy of said separate implantation step is lying between 40 keV and 60 keV for a BF₂ implant.

8. A method according to claim 4, wherein the implantation energy of said separate implantation step is lying between 150 keV and 300 keV for a B implant.

9. A device containing a high voltage p++/n-well junction, produced by the method of claims 1-8.

10. A device according to claim 9, wherein said device is a P-Drain Extended MOS.

11. A device according to claim 9, wherein said device is a high voltage floating p++/n-well diode.

12. A device according to claim 10 or 11, wherein the active area definition width of the p++ region (as designed) is lying between 1.6 µm and 8 µm.
